# EUROPEAN PATENT APPLICATION

(11) **EP 4 436 022 A1**
(43) Date of publication of application: **25.09.2024**
(21) Application number: 22896078.7
(22) Date of filing: 16.11.2022
(51) Int. Cl.: H02M 3/00, H05K 7/20

(54) **CONVERTER**

(30) Priority: 18.11.2021 KR 20210159092; 09.11.2022 KR 20220149077
(71) Applicant: LG INNOTEK CO., LTD., Seoul 07796 (KR)
(72) Inventor: JUNG, Jae Hoo, Seoul 07796 (KR); BAIK, Ji Hyeon, Seoul 07796 (KR); LEE, Yong Bin, Seoul 07796 (KR)
(74) Representative: Plasseraud IP
(86) International application number: PCT/KR2022/018144
(87) International publication number: WO 2023/090873

(57) **Abstract**

A converter comprises: a housing; an electronic component disposed in the housing; and heat dissipation fins protruding from the outer surface of the housing, wherein the heat dissipation fins comprise: a plurality of first heat dissipation fins disposed to be spaced apart from each other; and a plurality of second heat dissipation fins disposed to be spaced apart from each other and disposed between the plurality of first heat dissipation fins that are adjacent to each other, and wherein on the basis of a first direction, the lengths of the first heat dissipation fins are longer than the lengths of the second heat dissipation fins.

## Description

### [Technical Field]

The present embodiment relates to a converter.

### [Background Art]

Engine electrical devices (starting devices, ignition devices, and charging devices) and lighting devices are common as automobile electrical devices, but recently, most systems, including chassis electrical devices, are becoming electrically electronic as vehicles become more electronically controlled.

Various electrical components such as lamps, audio systems, heaters, and air conditioners installed in automobiles are designed to receive power from the battery when the car is stopped and from the generator when driving, and at this time, the generation capacity of the 14V power system is used as a normal power supply voltage.

Recently, along with the development of the information technology industry, various new technologies (motor-type power steering, Internet, and the like) aimed to enhance the convenience of automobiles are being adopted by vehicles, and in the future, it is expected that the development of new technologies that can maximally utilize the current automotive systems will continue.

A hybrid electric vehicle (HEV), regardless of soft or hard type, is equipped with a DC-DC converter (Low Voltage DC-DC Converter) for supplying an electric load (12V). In addition, the DC-DC converter, which serves as a generator (alternator) of a general gasoline vehicle, supplies a voltage of 12V for an electric load by lowering the high voltage of a main battery (usually a high-voltage battery of 144V or more).

A DC-DC converter refers to an electronic circuit device that converts DC power of a certain voltage into DC power of another voltage, and is used in various fields such as television receivers and electrical components of automobiles.

Inside a converter, a number of electrical elements that generate heat by driving are disposed. In general, the heat dissipation of the converter can be achieved by arranging one or more heat dissipation fins on an outer surface of the housing that forms the external shape. In other words, it is a structure in which the heat generated from the electrical elements is conducted to the outside through the housing and dissipated to the outside through the heat dissipation fin.

However, considering that the amount of heat generated is different for each electronic component and that the overall weight of the converter increases due to the arrangement region of heat dissipation fins, there is difficulty in designing the heat dissipation structure.

### [Detailed Description of the Invention]

### [Technical Subject]

The present embodiment is intended to provide a converter that can improve heat dissipation efficiency and reduce weight.

### [Technical Solution]

A converter according to the present embodiment comprises: a housing; an electronic component being disposed inside the housing; and heat dissipation fins being protruded from an outer surface of the housing, wherein the heat dissipation fins comprise: a plurality of first heat dissipation fins being disposed to be spaced apart from one another; and a plurality of second heat dissipation fins being disposed to be spaced apart from one another and disposed between the plurality of first heat dissipation fins that are adjacent to each other, and wherein based on a first direction, the lengths of the first heat dissipation fins are longer than the lengths of the second heat dissipation fins.

The outer surface of the housing includes: a first region where the first heat dissipation fins are disposed; and a second region where the first heat dissipation fins and the second heat dissipation fins are disposed, wherein the length of the second region is equal to or less than 1/2 of the sum of the length of the first region and the length of the second region.

A first gap is formed between pluralities of adjacent first heat dissipation fins in the first region, a second gap is formed between the first heat dissipation fins and the second heat dissipation fins in the second region, and the first gap may be larger than the second gap.

A third gap is formed between the two first heat dissipation fins being disposed at the center based on a second direction perpendicular to the first direction, and the third gap may be larger than the first gap.

A bracket being protruded outward and including a coupling hole is disposed on a side surface of the housing, and a rib connecting the bracket and the first heat dissipation fins or the bracket and the second heat dissipation fins may be included.

The rib may have a shape being protruded from a surface of the housing.

The first heat dissipation fins includes: a first guide region whose one end is disposed adjacent to one side surface of the housing; and a first heat dissipation region being connected to the first guide region and having one end being disposed adjacent to the other side surface of the housing, wherein an inclined surface may be disposed on a surface of the first guide region in a shape that the height of the protrusion from an outer surface of the housing increases as it approaches the first guide region.

The second heat dissipation fins includes: a second guide region whose one end is disposed adjacent to one end of the second region; and a second heat dissipation region being connected to the second guide region and having one end being disposed adjacent to the other end of the second region, wherein an inclined surface may be disposed on a surface of the second guide region in a shape that the height of the protrusion from an outer surface of the housing increases as it approaches the second heat dissipation region.

A connection portion having a larger cross-sectional area than other regions may be disposed between the first guide region and the first heat dissipation region.

A converter according to another embodiment comprises: a first housing; a second housing being disposed at a lower portion of the first housing; an electronic component being disposed between the first housing and the second housing; and heat dissipation fins being protruded downward from a lower surface of the second housing, wherein the heat dissipation fins comprise: a plurality of first heat dissipation fins being disposed to be spaced apart from one another; a plurality of second heat dissipation fins being disposed to be spaced apart from one another and disposed between a plurality of adjacent first heat dissipation fins, and wherein a lower surface of the second housing comprises: a first region where the first heat dissipation fins are disposed; and a second region where the first heat dissipation fins and the second heat dissipation fins are disposed.

### [Advantageous Effects]

The present embodiment has advantages in that heat dissipation efficiency is enhanced in regions where heat generation is concentrated and at the same time the weight of a converter can be reduced by forming a plurality of heat dissipation regions with an arrangement structure of heat dissipation fins of different lengths,

### [Brief Description of Drawings]

FIG. 1 is a perspective view illustrating an upper surface of a converter according to an embodiment of the present invention.
FIG. 2 is a perspective view illustrating a lower surface of a converter according to an embodiment of the present invention.
FIG. 3 is a view illustrating FIG. 2 from another angle.
FIG. 4 is a plan view illustrating a side surface of a converter according to an embodiment of the present invention.
FIG. 5 is an exploded perspective view of a converter according to an embodiment of the present invention.
FIG. 6 is a plan view illustrating a lower surface of a converter according to an embodiment of the present invention.
FIG. 7 is a plan view illustrating a lower surface of a converter according to a second embodiment of the present invention.
FIG. 8 is a table comparing the heat dissipation efficiency of the converter according to a second embodiment of the present invention with the converter according to a first embodiment of the present invention.

### [BEST MODE]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention.

In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or arranged in "on (above)" or "below (under)" of each component, "on (above)" or "below (under)" means that it includes not only the case where the two components are directly in contact with, but also the case where one or more other components are formed or arranged between the two components. In addition, when expressed as "on (above)" or "below (under)", the meaning of not only an upward direction but also a downward direction based on one component may be included.

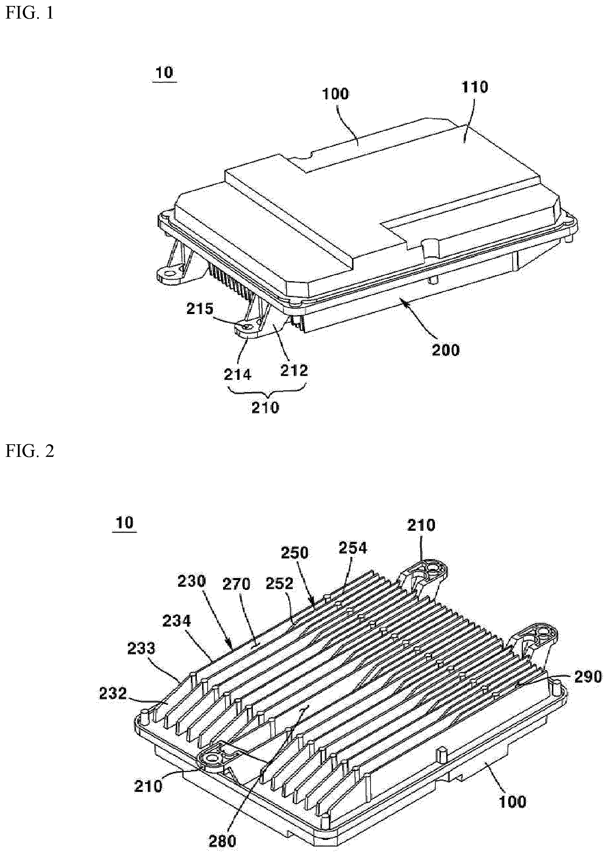

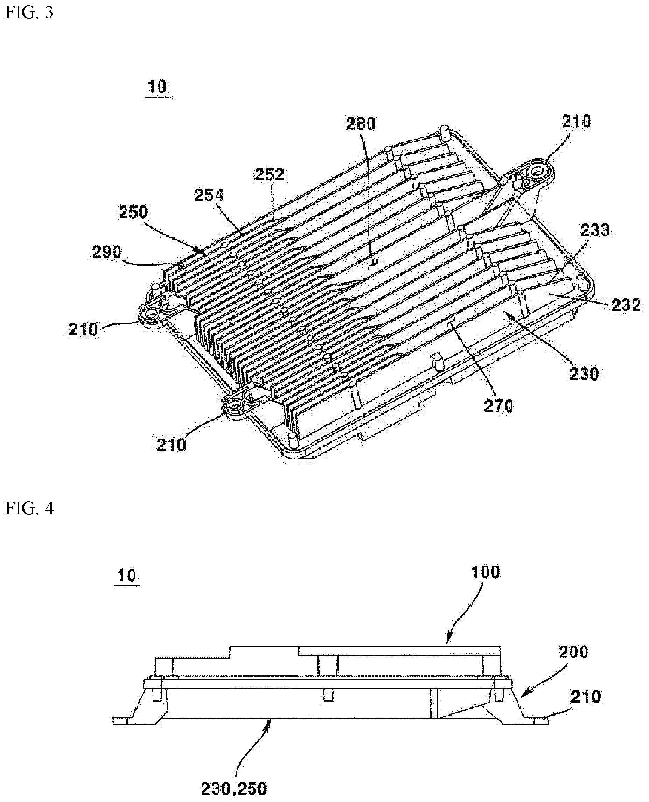

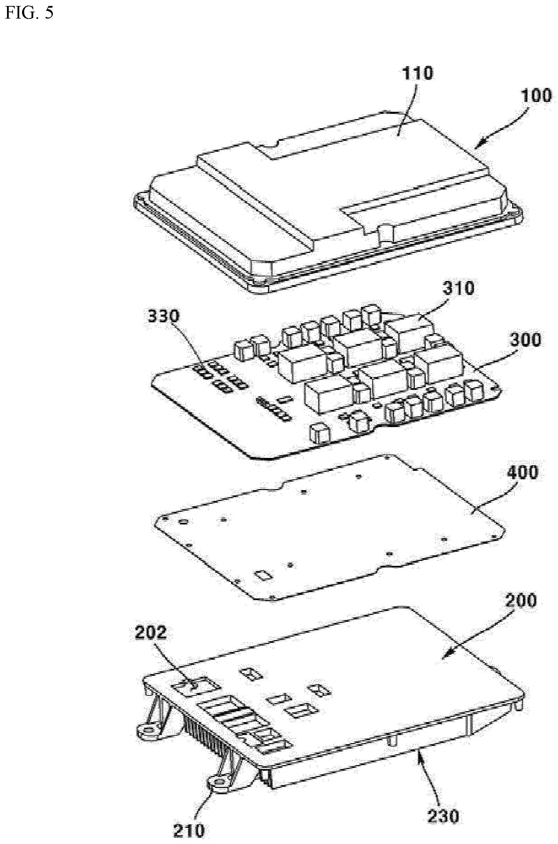

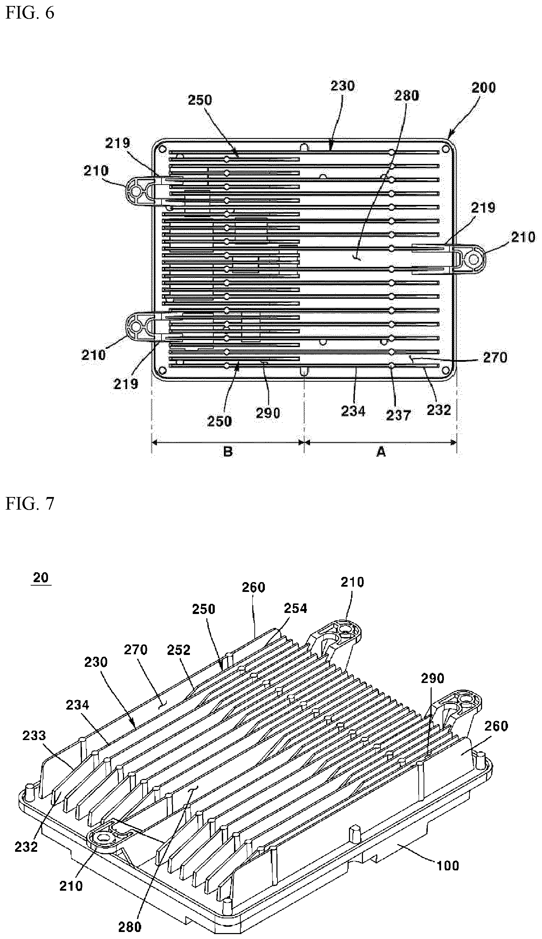

FIG. 1 is a perspective view illustrating an upper surface of a converter according to an embodiment of the present invention; FIG. 2 is a perspective view illustrating a lower surface of a converter according to an embodiment of the present invention; FIG. 3 is a view illustrating FIG. 2 from another angle; FIG. 4 is a plan view illustrating a side surface of a converter according to an embodiment of the present invention; FIG. 5 is an exploded perspective view of a converter according to an embodiment of the present invention; and FIG. 6 is a plan view illustrating a lower surface of a converter according to an embodiment of the present invention.

Referring to FIGS. 1 to 6, an external shape of a converter **10** according to an embodiment of the present invention may be formed by the coupling of the first housing **100** and the second housing **200.** The first housing **100** and the second housing **200** may be coupled in an up and down direction. The first housing **100** and the second housing **200** may include screw holes being formed in corresponding regions, and may be screw-coupled together.

The first housing **100** may be disposed at an upper portion of the second housing **200.** A protruded region **110** being protruded more upward than other regions may be disposed at an upper surface of the first housing **100.** A groove being recessed more upward than other regions may be formed on a lower surface of the first housing **100** facing the protruded region **110.** At least a portion of the electronic component **310** in the printed circuit board **300,** which will be described later, may be disposed inside the groove. The first housing **100** may be referred to as a cover in that it covers the upper portion of the component inside the converter **10.**

The second housing **200** may be disposed at a lower portion of the first housing **100.** The second housing **200** may include an upper surface facing the first housing **100** and a lower surface facing the upper surface. The second housing **200** may be referred to as a base in that it supports the components inside the converter **10** at a lower portion.

The first housing **100** and the second housing **200** may be formed of a metal material.

The second housing **200** may include a bracket **210** for coupling the converter **10** to the arrangement region of the converter **10.** The bracket **210** may have an end portion being protruded more outward than the side surface of the first housing **100** or the second housing **200.** The bracket **210** may include: a leg portion **212** protruding downward from the lower surface of the second housing **200;** and a coupling portion **214** protruding outward from the lower end of the leg portion **212.** The leg portion **212** may be disposed inclinedly so that the distance from the side surface of the first housing **100** or the side surface of the second housing **200** increases as it travels downward. The coupling portion **214** is disposed parallel to the first housing **100** or the second housing **200** and may include a coupling hole **215** penetrating from an upper surface to a lower surface. Accordingly, the screw passing through the coupling hole **215** is screw-coupled to the installation surface of the converter **10,** so that the converter **10** can be fixed to the installation surface.

The bracket **210** may be provided in plural and disposed to be spaced apart from one another. For example, three brackets **210** are provided, one is disposed on one side surface of the second housing **200,** and two may be disposed on the other side surface of the second housing **200** facing the one side surface. In this case, the bracket **210** being disposed on one side and the bracket **210** being disposed on the other side surface may be disposed so as not to be overlapped with each other.

A groove **202** being more recessed than other regions may be formed on an upper surface of the second housing **200.** A heat dissipating material with high thermal conductivity may be applied to the groove **202.** Or, at least a portion of electronic component being disposed on a surface of the printed circuit board **300,** which will be described later, may be disposed in the groove **202.**

Meanwhile, in this embodiment, the first housing **100** is disposed at an upper portion and the second housing **200** is disposed at a lower portion as an example, but this is not limited, and the second housing **200** is disposed at an upper portion, and the first housing **100** may be disposed at a lower portion. In addition, the first housing **100** and the second housing **200** may be formed as one body rather than a configuration separable from each other.

Electronic components for driving the converter **10** may be disposed in an internal space of the converter **10** being formed by the coupling of the first housing **100** and the second housing **200.** As an example, a printed circuit board **300** may be disposed in the internal space. The printed circuit board **300** is formed in a plate shape, and electronic components **310** and **330** may be disposed on at least one of the upper surface and lower surface. The electronic components **310** and **330** may generate heat as they are driven. The electronic components **310** and **330** may include: a transformer for voltage regulation; an inductor **310** for inductance; and one or more FET elements **330.**

A heat dissipation pad **400** may be disposed at a lower portion of the printed circuit board **300** among the internal space. The heat dissipation pad **400** is made of a material with high thermal conductivity and may have a plate shape. The upper surface of the heat dissipation pad **400** may be in contact with the lower surface of the printed circuit board **300,** and the lower surface of the heat dissipation pad **400** may be in contact with an upper surface of the second housing **200.** Accordingly, heat generated from the electronic components **310** and **330** inside the printed circuit board **300** may be transferred to the second housing **200** through the heat dissipation pad **400.**

Hereinafter, the heat dissipation structure of the converter **10** will be described.

The converter **10** may include heat dissipation fins. The heat dissipation fins may be formed to be protruded downward from a lower surface of the second housing **200.** The heat dissipation fins can enhance heat dissipation efficiency by increasing the cross-sectional area of the outer surface of the converter **10.** The heat dissipation fins may be disposed to be overlapped with the electronic components **310** and **330** in an up and down direction.

The lengthwise direction of the heat dissipation fins can be defined as a direction directing from one side surface of the second housing **200** where one of the plurality of brackets **210** is disposed toward the other side surface of the second housing **200,** where two of the plurality of brackets **210** are disposed. Hereinafter, the lengthwise direction of the heat dissipation fins, that is, the direction connecting one side surface and the other side surface of the second housing **200,** will be defined and described as a first direction.

The heat dissipation fins may include a plurality of first heat dissipation fins **230** and a plurality of second heat dissipation fins **250.** At least some of the plurality of first heat dissipation fins **230** may be disposed between adjacent second heat dissipation fins **250.** The plurality of second heat dissipation fins **250** may be disposed between adjacent first heat dissipation fins **230.** The length of the first heat dissipation fins **230** in a first direction may be longer than the length of the second heat dissipation fins **250** in a first direction. The length of the second heat dissipation fins **250** in a first direction may be less than or equal to 1/2 of the length of the first heat dissipation fins **230** in the first direction. The length of the second heat dissipation fins **250** in a first direction may be less than 1/2 of the length of the second housing **200** in a first direction.

As illustrated in FIG. 6, the lower surface of the second housing **200** can be divided into: a first region **A** adjacent to one side surface of the second housing **200** and in which only the first heat dissipation fins **230** are disposed; and a second region **B** adjacent to the other side surface of the second housing **200** and in which the first heat dissipation fins **230** and the second heat dissipation fins **250** are disposed together. The length of the second region **B** in a first direction may be equal to or less than 1/2 of the sum of the lengths of the first region **A** and the second region **B** in a first direction. The second region **B** may be disposed to be overlapped with the FET element **330** in an up and down direction.

The first heat dissipation fins **230** may be provided in plural and disposed to be spaced apart from each other. A first gap **270** may be formed between adjacent first heat dissipation fins **230** in the first region **A.** A second gap **290** may be formed between the first heat dissipation fins **230** and the second heat dissipation fins **250** in the second region **B.** At least one of the gaps between the pluralities of first heat dissipation fins **230** may have a different length from other gaps. For example, as illustrated in FIGS. 2 and 6, a third gap **280** is formed between two first heat dissipation fins **230** located at the center based on a second direction perpendicular to the first direction may be formed larger than the first gap **270** or the second gap **290.** Each of the two first heat dissipation fins **230** being disposed at the center based on the second direction may be connected to the leg portion **212** of the bracket **210.**

The first heat dissipation fins **230** may include a first guide region **232** and a first heat dissipation region **234.** One end of the first guide region **232** may be disposed adjacent to one side surface of the second housing **200.** An end of the first heat dissipation region **234** may be disposed adjacent to the other side surface of the second housing **200.** A first inclined surface **233** may be formed on a lower surface of the first guide region **232** in a shape in which the height of the protrusion from a lower surface of the second housing **200** increases as it approaches the first heat dissipation region **234.** Accordingly, air flowing in from one side surface of the second housing **200** can be easily guided to the region where the heat dissipation fins are disposed.

A connection portion **237** (see FIG. 6) having a larger cross-sectional area than other regions may be formed between the first guide region **232** and the first heat dissipation region **234.** Accordingly, the strength may increase in the connection region between the first guide region **232** and the first heat dissipation region **234.** The connection portions **237** may be provided in plural numbers and may be disposed in one region between one end and the other end of the first heat dissipation region **234.**

The first heat dissipation fins **230** may be connected to the bracket **210.** The first heat dissipation fins **230** may be connected to the leg portion **212** of the bracket **210.** The second housing **200** may include ribs **219** being protruded downward from a lower surface and connect the leg portion **212** and the first heat dissipation fins **230.** The thickness of the ribs **219** may be greater than the thickness of the first heat dissipation fins **230.** By connecting the first heat dissipation fins **230** and the bracket **210,** the strength of the first heat dissipation fins **230** can be reinforced.

The second heat dissipation fins **250** may be provided in plural numbers and disposed to be spaced apart from one another. The second heat dissipation fins **250** may be disposed in the second region **B.** The second heat dissipation fins **250** may be disposed between adjacent first heat dissipation fins **230.** A second gap **290** may be formed between the second heat dissipation fins **250** and the adjacent first heat dissipation fins **230.** The second gap **290** may be smaller than the first gap **270** or the third gap **280.**

The second heat dissipation fins **250** may include a second guide region **252** and a second heat dissipation region **254.** The second guide region **252** has one end adjacent to one end of the second region **B,** and the second heat dissipation region **254** may have an end adjacent to the other end of the second region **B.** A second inclined surface may be formed on a lower surface of the second guide region **252** in a shape in which the height of the protrusion from the lower surface of the second housing **200** increases as it approaches the second heat dissipation region **254.** Accordingly, the air passing through the first region **A** can be easily guided to the second region **B.**

The second heat dissipation fins **250** may be connected to the bracket **210.** The second heat dissipation fins **250** may be connected to the leg portion **212** of the bracket **210.** The second housing **200** may include ribs **219** being protruded downward from the lower surface and connect the leg portion **212** and the second heat dissipation fins **250.** The thickness of the ribs **219** may be greater than the thickness of the second heat dissipation fins **250.** By connecting the second heat dissipation fins **250** and the bracket **210,** the strength of the second heat dissipation fins **250** can be reinforced.

Based on a second direction, two second heat dissipation fins **250** may be disposed between the two first heat dissipation fins **230** being disposed in the center. In this case, the first heat dissipation fins **230** may not be disposed between the two second heat dissipation fins **250.** In other words, two second heat dissipation fins **250** may be disposed in the third gap **280.** Accordingly, the center of gravity of the converter **10** can be formed uniformly with respect to the center.

As illustrated in FIG. 4, a lower surface of the bracket **210** and a lower surface of the heat dissipation fins may be disposed to be stepped from each other. The lower surface of the bracket **210** may be disposed lower than the lower surface of the heat dissipation fins.

According to the above structure, a plurality of heat dissipation regions are formed by arranging heat dissipation fins of different lengths, which has the advantage of improving heat dissipation efficiency in the region where heat generation is concentrated and at the same time reducing the weight of the converter.

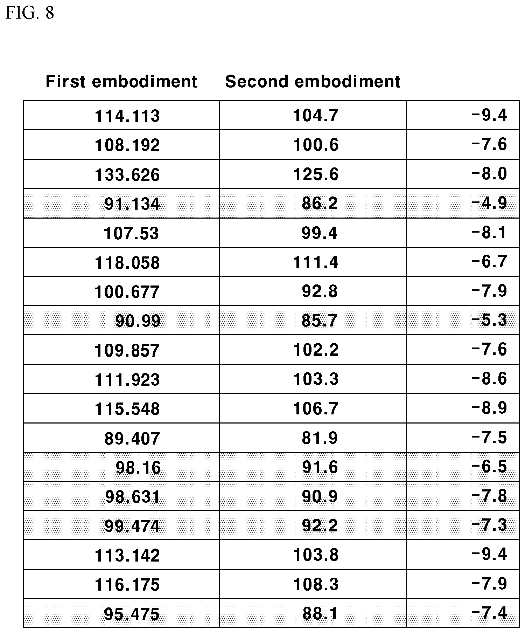

FIG. 7 is a plan view illustrating a lower surface of a converter according to a second embodiment of the present invention; and FIG. 8 is a table comparing the heat dissipation efficiency of a converter according to a second embodiment of the present invention with a converter according to a first embodiment of the present invention.

The present embodiment is the same as the first embodiment in other respects, except that a guide fin is added to the edge of the region where heat dissipation fins are formed. Therefore, hereinafter, only the characteristic parts of the present embodiment will be described, and the description of the first embodiment will be cited as a reference for the remaining parts.

Referring to FIGS. 7 and 8, guide fins **260** may be disposed on an outer surface of the second housing **200** according to the present embodiment. The guide fins **260** may be disposed outside first heat dissipation fins **230** and second heat dissipation fins **250.** When a region where the first heat dissipation fins **230** and the second heat dissipation fins **250** are formed on an outer surface of the second housing **200** is referred to as a heat dissipation region, the guide fins **260** may form a boundary of the heat dissipation region. The guide fins **260** may be provided in plural numbers and may be respectively disposed on both sides of the heat dissipation region. The guide fins **260** may be provided in plural numbers and disposed to be spaced apart from one another along a first direction. The first heat dissipation fins **230** and the second heat dissipation fins **250** may be disposed inside the plurality of guide fins **260.** The plurality of guide fins **260** may be disposed adjacent to both sides of the lower surface of the second housing **200,** respectively.

The protrusion heights of the guide fins **260** from the outer surface of the second housing **200** is the protrusion heights of the first heat dissipation fins **230** from the outer surface of the second housing **200** or the outer surface of the second housing **200,** and may be formed to be larger than the protrusion heights of the second heat dissipation fins **250.**

The guide fins **260** are formed in a plate shape and may be disposed perpendicular to the lower surface of the second housing **200.**

Based on a second direction perpendicular to the first direction, the lengths of the guide fins **260** may correspond to the lengths of the first heat dissipation fins **230** or may be formed to be longer. Based on a lengthwise direction of the guide fins **260,** one ends of the guide fins **260** are disposed to form the same heights as one ends of the first heat dissipation fins **230,** and the other ends of the guide fins **260** may be disposed to form the same heights as the other ends of the first heat dissipation fins **230** or the other ends of the second heat dissipation fins **250.**

According to the above structure, the flow of air flowing through the heat dissipation region is guided through the guide fins **260,** so there is an advantage in that heat dissipation efficiency can be further improved. As illustrated in FIG. 8, it can be confirmed that the heat dissipation effect is superior to that of the converter according to the first embodiment due to the air guide structure through the guide fins **260.**

In addition, since the heat dissipation region and other regions are partitioned by the guide fins **260,** there is an advantage that the space within the heat dissipation region can be protected from other regions, and the degree of freedom in design regarding the arrangement of the plurality of heat dissipation fins within the heat dissipation area can be increased.

Meanwhile, since the guide fins **260** are disposed at the outermost part of the heat dissipation region, they may also be referred to as outermost fins.

In the above description, it is described that all the components constituting the embodiments of the present invention are combined or operated in one, but the present invention is not necessarily limited to these embodiments. In other words, within the scope of the present invention, all of the components may be selectively operated in combination with one or more. In addition, the terms "comprise", "include" or "having" described above mean that the corresponding component may be inherent unless specifically stated otherwise, and thus it should be construed that it does not exclude other components, but further include other components instead. All terms, including technical and scientific terms, have the same meaning as commonly understood by one of ordinary skill in the art unless otherwise defined. Terms used generally, such as terms defined in a dictionary, should be interpreted to coincide with the contextual meaning of the related art, and shall not be interpreted in an ideal or excessively formal sense unless explicitly defined in the present invention.

The above description is merely illustrative of the technical idea of the present invention, and those skilled in the art to which the present invention pertains may make various modifications and changes without departing from the essential characteristics of the present invention. Therefore, the embodiments disclosed in the present invention are not intended to limit the technical idea of the present invention but to describe the present invention, and the scope of the technical idea of the present invention is not limited by these embodiments. The protection scope of the present invention should be interpreted by the following claims, and all technical ideas within the equivalent scope should be interpreted as being included in the scope of the present invention.

## Claims

1. A converter comprising:
a housing;
an electronic component disposed inside the housing; and
heat dissipation fins protruded from an outer surface of the housing,
wherein the heat dissipation fins comprise a plurality of first heat dissipation fins disposed to be spaced apart from one another, and a plurality of second heat dissipation fins disposed to be spaced apart from one another and disposed between the plurality of first heat dissipation fins that are adjacent to each other, and
wherein based on a first direction, a lengths of the first heat dissipation fins are longer than a lengths of the second heat dissipation fins.

2. The converter according to claim 1,
wherein the outer surface of the housing includes a first region where the first heat dissipation fins are disposed, and a second region where the first heat dissipation fins and the second heat dissipation fins are disposed, and
wherein a length of the second region is equal to or less than 1/2 of a sum of a length of the first region and the length of the second region.

3. The converter according to claim 2,
wherein a first gap is formed between pluralities of adjacent first heat dissipation fins in the first region,
wherein a second gap is formed between the first heat dissipation fins and the second heat dissipation fins in the second region, and
wherein the first gap is larger than the second gap.

4. The converter according to claim 3,
wherein a third gap is formed between the two first heat dissipation fins disposed at the center based on a second direction perpendicular to the first direction, and
wherein the third gap is larger than the first gap.

5. The converter according to claim 1,
wherein a bracket protruded outward and including a coupling hole is disposed on a side surface of the housing, and
wherein a rib connecting the bracket and the first heat dissipation fins or the bracket and the second heat dissipation fins is included.

6. The converter according to claim 5,
wherein the rib has a shape protruded from a surface of the housing.

7. The converter according to claim 1,
wherein the first heat dissipation fins includes a first guide region whose one end is disposed adjacent to one side surface of the housing, and a first heat dissipation region connected to the first guide region and having one end disposed adjacent to the other side surface of the housing, and
wherein an inclined surface is disposed on a surface of the first guide region in a shape that the height of the protrusion from an outer surface of the housing increases as it approaches the first guide region.

8. The converter according to claim 2,
wherein the second heat dissipation fins includes a second guide region whose one end is disposed adjacent to one end of the second region, and a second heat dissipation region connected to the second guide region and having one end disposed adjacent to the other end of the second region, and
wherein an inclined surface is disposed on a surface of the second guide region in a shape that the height of the protrusion from an outer surface of the housing increases as it approaches the second heat dissipation region.

9. The converter according to claim 7,
wherein a connection portion having a larger cross-sectional area than other regions is disposed between the first guide region and the first heat dissipation region.

10. A converter comprising:
a first housing;
a second housing disposed at a lower portion of the first housing;
an electronic component disposed between the first housing and the second housing; and
heat dissipation fins protruded downward from a lower surface of the second housing,
wherein the heat dissipation fins comprise a plurality of first heat dissipation fins disposed to be spaced apart from one another, a plurality of second heat dissipation fins disposed to be spaced apart from one another and disposed between a plurality of adjacent first heat dissipation fins, and
wherein a lower surface of the second housing comprises a first region where the first heat dissipation fins are disposed, and a second region where the first heat dissipation fins and the second heat dissipation fins are disposed.
